# EUROPÄISCHE PATENTSCHRIFT

(11) **EP 1 080 615 B1**
(45) Veröffentlichungstag und Bekanntmachung des Hinweises auf die Patenterteilung: **13.02.2002**
(21) Anmeldenummer: 99930999.0
(22) Anmeldetag: 03.05.1999
(51) Int. Cl.: H05K 3/18, H05K 3/24, H05K 3/42

(54) **MEHRFACHNUTZEN FÜR ELEKTRONISCHE BAUELEMENTE, SOWIE VERFAHREN ZUM AUFBAU VON BUMPS, LOTRAHMEN, ABSTANDSHALTER UND DERGL. AUF DEM MEHRFACHNUTZEN**
MULTIPLE PRINTED PANEL FOR ELECTRONICS COMPONENTS, AND METHOD FOR CONSTRUCTING BUMPS, SOLDERING FRAMES, SPACERS AND SIMILAR ON SAID MULTIPLE PRINTED PANEL.
FLAN IMPRIME MULTIPLE POUR COMPOSANTS ELECTRONIQUES ET PROCEDE PERMETTANT DE REALISER DES BOSSES, DES CADRES DE BRASAGE, DES ECARTEURS ET SIMILAIRES SUR LE FLAN IMPRIME MULTIPLE

(30) Priorität: 20.05.1998 DE 19822794
(43) Veröffentlichungstag der Anmeldung: 07.03.2001
(73) Patentinhaber: EPCOS AG, 81541 München (DE)
(72) Erfinder: STELZL, Alois, D-81549 München (DE); KRÜGER, Hans, D-81737 München (DE); WEIDNER, Karl, D-81245 München (DE); WOSSLER, Manfred, D-81479 München (DE)
(74) Vertreter: Epping, Wilhelm, Dipl.-Ing.
(86) Internationale Anmeldenummer: DE9901315
(87) Internationale Veröffentlichungsnummer: WO9960830

(56) Entgegenhaltungen:
- EP-A- 0 637 871
- WO-A-97/02727
- WO-A-97/45955
- PATENT ABSTRACTS OF JAPAN vol. 199, no. 604, 30. April 1996 (1996-04-30) -& JP 07 321114 A (SHARP CORP), 8. Dezember 1995 (1995-12-08)
- PATENT ABSTRACTS OF JAPAN vol. 199, no. 508, 29. September 1995 (1995-09-29) -& JP 07 122838 A (KYOCERA CORP), 12. Mai 1995 (1995-05-12)
- PATENT ABSTRACTS OF JAPAN vol. 199, no. 711, 28. November 1997 (1997-11-28) -& JP 09 181443 A (MURATA MFG CO LTD), 11. Juli 1997 (1997-07-11)

## Beschreibung

Die Erfindung betrifft einen Mehrfachnutzen, der in Einzelnutzen für elektronische Bauelemente, insbesondere akustische Oberflächenwellen-Bauelemente, vereinzelbar ist, die jeweils zur Kontaktierung von Chips in Flip-Chip-Technik auf den Einzelnutzen und zur Kontaktierung der Einzelnutzen in SMD-Technik mit äußeren Anschlüssen geeignet sind. Ferner betrifft die Erfindung ein Verfahren zum Aufbau von Bumps, Lotrahmen und dergl. auf dem Mehrfachnutzen.

Der Aufbau der für die Kontaktierung von Chips in Flip-Chip-Technik notwendigen Bumps, auch Lotkugeln genannt, und der zur Fixierung der Chip-Metallkappen erforderlichen Lotrahmen auf Keramik- und gedruckten Leiterplatten-Mehrfachnutzen erfolgt bislang mittels Sieb- bzw. Schablonendruck.

Verbunden mit dieser Art des Aufdrucks von Bumps und Lotrahmen sind teuere, je elektronische Bauelemententype unterschiedliche Schablonen und damit auch typengebundene Spezialwerkzeuge zur Herstellung der Schablonen.

Zusätzliche Probleme beim Schablonendruck treten durch einen Verzug des Substratmaterials, z.B. der Keramik des Mehrfachnutzens und damit der Einzelnutzen auf, da in allen diesen Fällen die gewünschte exakte geometrische Anordnung der Bumps auf den Einzelnutzen nicht möglich ist. Gleiches gilt auch, wenngleich mit geringeren schädlichen Auswirkungen, für die Lotrahmen und für eventuelle Abstandshalter zur Gewährleistung des notwendigen Abstands zwischen Chip und Einzelnutzen bzw. Substrat.

Die japanische Patentschritt JP 09 181 443 offenbart einen derartigen Mehrfachnutzen, wobei der Mehrfachnutzen je Einzelnutzen metallisierte Flächen für die Kontaktierung mit Bumps aufweist, die an einem im Mehrfachnutzen integrierten Netzwerk liegen, das zu einem Anschlußpol hinführt.

Die vorliegende Erfindung hat sich daher die Aufgabe gestellt, einen in Einzelnutzen vereinzelbaren Mehrfachnutzen der eingangs genannten Art zu schaffen, der die vorher erwähnten Nachteile behebt, d.h. wenig aufwendig ist und ein Verfahren zum gemeinsamen Aufbau der Bumps und Lotrahmen und, falls es erforderlich ist, auch der Abstandshalter und dergl. ermöglicht, das unabhängig vom Substratmaterial des Nutzens stets die üblicherweise typengebundene Geometrie des Bumps, Lotrahmen und dergl. exakt gewährleistet.

Zur Lösung der Aufgabe schlägt die Erfindung bei einem Mehrfachnutzen gemäß Oberbegriff des Anspruchs 1 vor, daß weitere metallisierte Flächen zum Aufbau von Lotrahmen für die Metallkappen für Chips, ggf. für Abstandshalter und sonstige erforderliche Elemente liegen jeweils an zusätzlichen, im Mehrfachnutzen integrierten Netzwerken, die zu entsprechenden weiteren Anschlußpolen hinführen.

Hingegen erübrigen sich integrierte Netzwerke und dementsprechend ihre elektrische Anbindung an Anschlußpole in all den Fällen, in denen leitfähige Flächen nicht galvanisiert, z.B. mit Bumps versehen werden sollen.

Mittels dieser Mehrfachnutzen können die für die Bumps, Lotrahmen und dergl. gewunschten metallischen Schichten, z.B. SnPb-Schichten, galvanisch auf die metallisierten Flächen abgeschieden werden, wobei die Anschlußpole der einzelnen Netzwerke zusammengeschaltet oder getrennt in zeitlichem Abstand aktiviert werden, je nachdem, ob gleiche oder unterschiedliche metallische Schichten, Schichtzusammensetzungen und Schichtdicken für die Bumps, Lotrahmen und dergl. gefordert werden.

Die Schichtdicke läßt sich über die Ladungsmenge, d.h. dem Produkt aus Stromstärke und Zeit, sehr genau einstellen. Verzugsprobleme der beim Schablonendruck erwähnten Art treten nicht auf. Schablonen und die Fertigung entsprechender, typengebundener Spezialwerkzeuge hierfür entfallen gleichfalls.

Weitere Merkmale der Erfindung sind den Unteransprüchen und der Zeichnung entnehmbar. Es zeigt:
- Fig. 1: einen Mehrfachnutzen gemäß der Erfindung in Draufsicht und teils gebrochener Darstellung;
- Fig. 2:: gleichfalls in gebrochener Darstellung einen Querschnitt durch einen Einzelnutzen in Fig. 1 mit einem gemäß dem Verfahren nach der Erfindung in Flip-Chip-Technik mit dem Einzelnutzen kontaktierten und mit einer Metallkappe bestückten elektronischen Bauelement, insbesondere OFW-Bauelement;
- Fig. 3 bis 5: in geschnittener und teils gebrochener Darstellung ein Ausführungsbeispiel zum Aufbau eines Bumps gemäß dem Verfahren nach der Erfindung.

Gleiche Elemente in den Zeichnungen sind dabei mit gleichen Bezugszeichen bezeichnet.

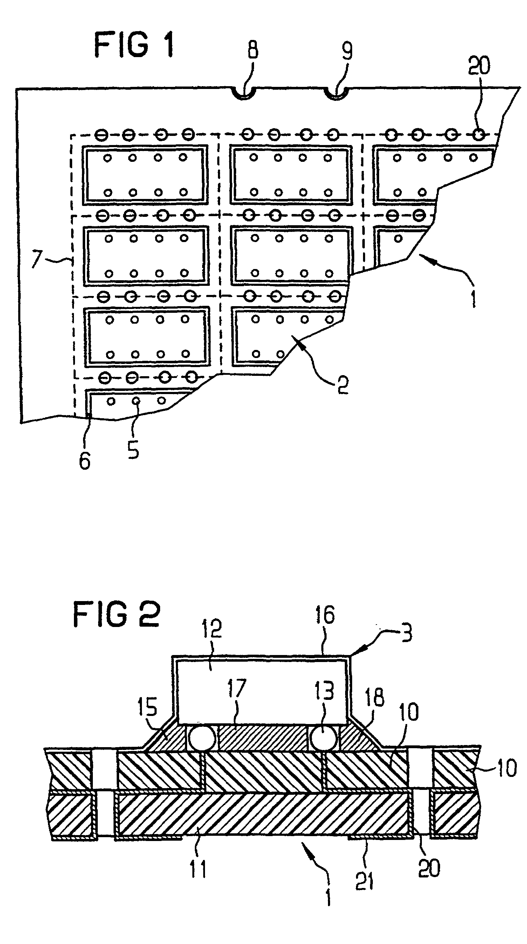

Der Mehrfachnutzen 1 nach Fig. 1, z.B. ein Keramik- oder gedruckter Leiterplattennutzen, ist in eine Vielzahl von in Reihen und Spalten angeordneten Einzelnutzen 2 unterteilt, die jeweils längs einer strichliniert angedeuteten Trennlinie 7 vereinzelbar sind. Je gewünschter, jeweils vom Bauelemententyp abhängiger exakter geometrischer Anordnung der Lotrahmen 15 und der Bumps 13 - s. Fig. 2 - weist jeder Einzelnutzen 2 metallisierte Flächen 5, 6 auf, die teils - s. die Flächen 6 für die Lotrahmen 15 - in Siebdrucktechnik aufgebracht sind, teils Stirnflächen von Durchkontaktierungen 20 sind.

Der Mehrfachnutzen 1 an sich besteht - s. Fig. 2 - aus zwei Lagen 10, 11, z.B. aus Keramik oder gedruckten Leiterplatten. Bevorzugt im Bereich zwischen den Grenzflächen dieser Lagen sind Teile eines oder mehrerer, jweils voneinander getrennter Netzwerke angeordnet, die einerseits jeweils zu Anschlußpolen 8 bzw. 9 und andererseits zu den metallisierten Flächen 5 für Bumps bzw. 6 für Lotrahmen hinführen.

Bei Vereinzelung des Mehrfachnutzens 1 längs der Trennlinie 7 in die Einzelnutzen 2, was nach galvanischem Aufbau der Pumps 13, der Lotrahmen 15 und schließlich nach Schaffung des Endprodukts 3 gemäß Fig. 2 erfolgt, werden die üblichen gestalteten und daher mit Rücksicht auf die Übersichtlichkeit der Zeichnung nicht dargestellten Netzwerke gleichfalls aufgetrennt und so u.a. die zunächst gegebenen Kontakte zwischen den einzelnen metallisierten Flächen 5 jedes Einzelnutzens 2 unterbrochen.

Wie Figur 1 und 2 zeigt, ist die Trennlinie 7 bevorzugt so gewählt, daß bei Vereinzelung des Mehrfachnutzens 1 in seine Einzelnutzen 2 die Durchkontaktierungen 20, welche die SMD-Kontaktelemente 21 mit metallisierten Flächen 5 bzw. mit den galvanisch aufgebrachten Bumps 13 verbinden, im Bereich der Lage 11 des Mehrfachnutzens 1 in zwei Durchkontaktierungen aufgetrennt werden, die jeweils benachbarten Einzelnutzen 2 zugeordnet sind.

Das Endprodukt 3, zu dessen Schaffung das später erläuterte Verfahren beiträgt, weist - so wie es in Fig. 2 dargestellt ist - einen Chip 12, z.B. ein piezoelektrisches Substrat auf, das mittels der Bumps 13 dessen aktive elektrische Strukturen mit SMD-Kontaktelementen 21 kontaktiert. Das Chip 12 an sich ist durch eine Metallkappe 16 geschützt, die auf den galvanisch aufgebrachten Lotrahmen 15 aufgelötet ist. Ferner ist zwischen Chip 12 und Nutzen eine anmelderseits PROTEC genannte Deck- bzw. Schutzschicht 17 vorgesehen und der freie Raum zwischen der Deckschicht 17 und der Metallkappe 16 z.B. mit Epoxidharz 18 unterfüllt.

Die erfindungsgemäß vorgeschlagene Anwendung des galvanischen Verfahrens zum Abscheiden der Metallschicht auf die hierfür vorgesehenen metallisierten Flächen 5, 6 zeichnet sich durch zahlreiche Vorteile aus.

So ist z.B. die Schichtdicke über die Ladungsmenge, d.h. über das exakt steuerbare Produkt aus Stromstärke und Zeit genau einstellbar. Je nach Schichtaufbau und Schichtzusammensetzung, d.h. z.B. je nach gewünschter gleicher oder unterschiedlicher Schichtzusammensetzung für die Lotrahmen 15 und die Bumps 13 können die Netzwerke über ihre Anschlußpole 8, 9 zeitlich zusammengeschaltet oder zeitlich getrennt angeschaltet werden.

Letztes empfiehlt sich z.B. bei galvanischer Abscheidung von Metallschichten für Lotrahmen 15, z.B. SnPb-Schichten auf die metallisierten Flächen 6, da für die SnPb-Schichten des Lotrahmens 15 ein Schmelzpunkt gefordert wird, der höher ist als jener der Bumps 13.

Das gewählte Verfahren ermöglicht darüberhinaus die galvanische Abscheidung von unterschiedlichen Metallen, z.B. von SnPb in einer Folge übereinander, was in all den Fällen vorteilhaft ist, bei denen die Schicht nicht bereits als Legierung abscheidbar ist, diese folglich erst beim Schmelzen der aufgebrachten Metalle erhalten wird.

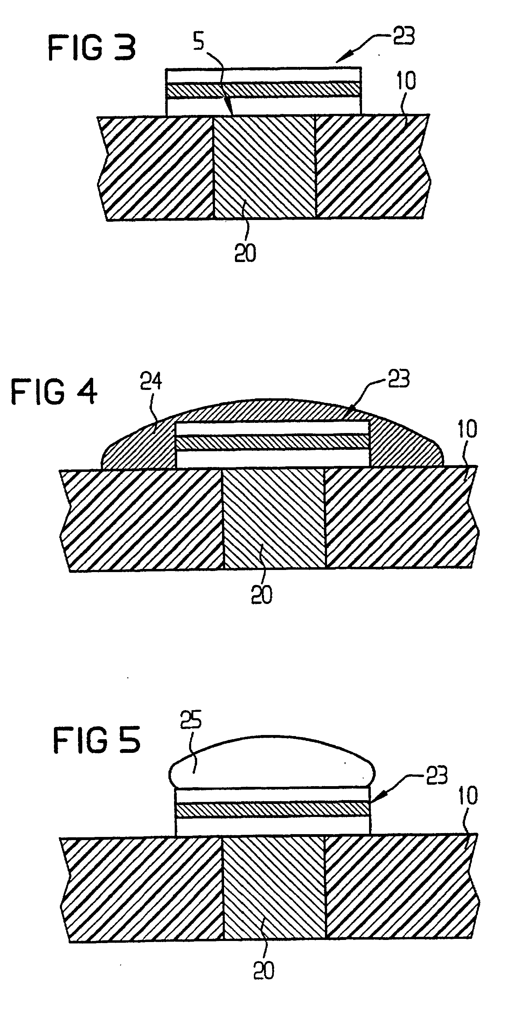

Falls die zur Kontaktierung von Bumps 13 vorgesehene und durch die lichte Weite der Durchkontaktierung 20 in der Lage 10 des Mehrfachnutzens 1 vorgegebene metallisierte Fläche 5 den geforderten Bumpgrößen nicht genügt, empfiehlt es sich, gemäß den in Fig. 3 bis 5 aufgezeigten Schritten vorzugehen. Dabei wird zunächst durch Auftrag einer Schichtfolge 23, die z.B. aus einer teils in Siebdrucktechnik, galvanisch oder stromlos abgeschiedenen Schichtfolge W-Ni-Au besteht, die metallisierte Fläche 5 vergrößert. Anschließend werden die zum Aufbau von Bumps erforderlichen Metallschichten 24 galvanisch abgeschieden und auf ihre Schmelztemperatur erhitzt, was zu den in Fig. 5 gezeigten Bump-Kugeln 25 größeren Durchmessers führt.

## Patentansprüche

1. Mehrfachnutzen, der mehrlagig ausgebildet ist, der in Einzelnutzen für elektronische Bauelemente, insbesondere akustische Oberflächenwellen-Bauelemente, vereinzelbar ist, die jeweils zur Kontaktierung von Chips in Flip-Chip-Technik auf den Einzelnutzen und zur Kontaktierung der Einzelnutzen in SMD-Technik mit äußeren Anschlüssen geeignet sind, wobei
der Mehrfachnutzen (1) je Einzelnutzen (2) metallisierte Flächen (5) für die Kontaktierung mit Bumps (13) aufweist, die an einem im Mehrfachnutzen integrierten Netzwerk liegen, das Kontakt zwischen den metallisierten Flächen herstellt, und das zu einem Anschlußpol (8) hinführt, **dadurch gekennzeichnet, daß**
weitere metallisierte Flächen vorgesehen sind, die an einem zusätzlichen integrierten Netzwerk liegen, das zu weiteren Anschlußpolen hinführt, wobei erste und zweite metallisierte Flächen zum Aufbau unterschiedlicher Elemente aus unterschiedlichen Materialien vorgesehen sind, und wobei die Netzwerke zwischen den Lagen des mehrlagigen Nutzens angeordnet sind.

2. Mehrfachnutzen nach Anspruch 1,
bei dem die Anschlußpole (8, 9) der Netzwerke an den Stirnseiten des Mehrfachnutzens (1) angeordnet sind.

3. Mehrfachnutzen nach Anspruch 1 oder 2,
bei dem die Anschlußpole (8, 9) der beiden Netzwerke miteinander kontaktiert sind.

4. Mehrfachnutzen nach Anspruch 1 bis 3,
bei dem der Mehrfachnutzen (1) ein mehrlagiger Keramik- oder gedruckter Leiterplatten-Mehrfachnutzen ist, mit im Bereich der Trennflächen zwischen den Lagen (10, 11) angeordneten Netzwerken.

5. Mehrfachnutzen nach Anspruch 1,
bei dem die einzelnen Kontaktflächen (5) für die Bumps (13) zusätzlich zu ihren Anschlüssen am Netzwerk jeweils über Durchkontaktierungen (20) im Mehrfachnutzen (1) mit entsprechenden SMD-Kontaktelementen (21) verbunden sind.

6. Verfahren zum Auftrag von metallischen Schichten auf den für Bumps, Lotrahmen, Abstandshalter und dergl. bestimmten metallisierten Flächen des Mehrfachnutzens gemäß Anspruch 1,
**dadurch gekennzeichnet,**
**daß** die metallischen Schichten galvanisch auf die metallisierten Flächen (5, 6) abgeschieden werden, wobei die Netzwerke für unterschiedlich zu erzeugende Elemente zeitlich getrennt angeschaltet werden und wobei unterschiedliche Metalle abgeschieden werden.

7. Verfahren nach Anspruch 6,
bei dem auf die metallisierten Flächen (5, 6) des Mehrfachnutzens (1) SnPb-Legierungen galvanisch abgeschieden werden.

8. Verfahren nach Anspruch 6 oder 7,
bei dem zum Aufbau von Bumps (13) SnPb-Schichten auf den für die Kontaktierung mit Bumps vorgesehenen metallisierten Flächen (5) des Mehrfachnutzens (1) galvanisch abgeschieden und anschließend auf ihre Schmelztemperatur erhitzt werden.

9. Verfahren nach Anspruch 8,
bei dem die zur Kontaktierung von Bumps (13) vorgesehenen und durch die lichte Weite der Durchkontaktierungen (20) im Mehrfachnutzen (1) vorgegebenen, metallisierten Flächen (5) des Mehrfachnutzens durch Auftrag einer Schichtfolge (23) von Metallen vergrößert und anschließend die zum Aufbau von Bumps erforderlichen Metallschichten galvanisch abgeschieden und auf ihre Schmelztemperatur erhitzt werden.

10. Verfahren nach Anspruch 9,
bei dem eine Schichtfolge W-Ni-Au (23) in Siebdrucktechnik, galvanisch oder stromlos abgeschieden wird.

## Claims

1. Multiple blank, which is of multilayer design, which can be separated into individual blanks for electronic components, in particular surface acoustic wave components, which are each suitable for contact to be made with chips in the flip-chip technique on the individual blanks and for contact to be made with the individual blanks in the SMD technique, using external connections, the multiple blank (1) having, for each individual blank (2), metallized areas (5) to make contact with bumps (13), said areas being located on a network which is integrated in the multiple blank, produces the contact between the metallized areas and leads to a connecting terminal (8), **characterized in that** further metallized areas are provided which are located on an additional integrated network which leads to further connecting terminals, first and second metallized areas being provided to build up different elements from different materials, and the networks being arranged between the layers of the multilayer blank.

2. Multiple blank according to Claim 1, in which the connecting terminals (8, 9) of the networks are arranged at the ends of the multiple blank (1).

3. Multiple blank according to Claim 1 or 2, in which the connecting terminals (8, 9) of the two networks make contact with each other.

4. Multiple blank according to Claims 1 to 3, in which the multiple blank (1) is a multilayer ceramic or printed circuit board multiple blank, with networks arranged in the area of the dividing faces between the layers (10, 11).

5. Multiple blank according to Claim 1, in which the individual contact areas (5) for the bumps (13), in addition to their connections to the network, are each connected to corresponding SMD contact elements (21) via plated-through holes (20) in the multiple blank (1).

6. Method of applying metallic layers to the metallized areas intended for bumps, solder frames, spacers and the like of the multiple blank according to Claim 1, **characterized in that** the metallic layers are deposited by electroplating on the metallized areas (5, 6), the networks for elements to be produced differently being connected up at separate times and different metals being deposited.

7. Method according to Claim 6, in which SnPb alloys are deposited by electroplating on the metallized areas (5, 6) of the multiple blank (1).

8. Method according to Claim 6 or 7, in which, to build up bumps (13), SnPb layers are deposited by electroplating on the metallized areas (5) of the multiple blank (1) that are provided to make contact with bumps, and are subsequently heated to their melting point.

9. Method according to Claim 8, in which the metallized areas (5) provided on the multiple blank (1) to make contact with bumps (13) and predefined by the clear width of the plated-through holes (20) in the multiple blank (1) are enlarged by application of a sequence of layers (23) of metals, and then the metal layers needed to build up bumps are deposited by electroplating and are heated to their melting point.

10. Method according to Claim 9, in which a sequence of layers, W-Ni-Au (23), is deposited by a screen printing technique, electroplating or electroless deposition.

## Revendications

1. Flan imprimé multiple constitué de plusieurs couches, qui peut être individualisé en des flans individuels pour des composants électroniques, notamment des composants acoustiques à ondes de surface, qui conviennent respectivement pour assurer le contact de puces suivant la technique Flip-Chip sur les flans individuels et pour assurer le contact des flans individuels dans la technique SMD avec des bornes extérieures, dans lequel le flan (1) multiple comporte pour chaque flan (2) individuel des surfaces (5) métallisées pour assurer le contact avec des bossages (13) qui se trouvent sur un réseau intégré au flan multiple, qui procurent le contact entre les surfaces métallisées et qui mènent à un pôle (8) de raccordement, **caractérisé**
**en ce qu'**il est prévu d'autres surfaces métallisées qui se trouvent sur un réseau intégré supplémentaire qui mène à d'autres pôles de raccordement, les première et deuxième surfaces métallisées étant prévues pour la formation d'éléments différents en des matériaux différents et les réseaux étant disposés entre les couches du flan à plusieurs couches.

2. Flan multiple suivant la revendication 1, dans lequel les pôles (8, 9) de raccordement des réseaux sont disposés sur les côtés frontaux du flan (1) multiple.

3. Flan multiple suivant la revendication 1 ou 2, dans lequel les pôles (8, 9) de raccordement des deux réseaux sont mis en contact l'un avec l'autre.

4. Flan multiple suivant la revendication 1 à 3, dans lequel le flan (1) multiple est un flan multiple de plaquettes à circuit imprimé ou en céramique à plusieurs couches ayant des réseaux disposés dans la région des surfaces de séparation entre les couches (10, 11).

5. Flan multiple suivant la revendication 1, dans lequel les surfaces (5) de contact individuel pour les bossages (13) sont reliées en plus de leurs bornes au réseau, respectivement par des contacts (20) traversants ménagés dans le flan (1) multiple, à des éléments (21) de contact SMD correspondants.

6. Procédé de dépôt de couches métalliques sur des surfaces métallisées du flan multiple destinées à des bossages, à des cadres de brasage, à des espaceurs et analogues suivant la revendication 1, **caractérisé en ce qu'**il consiste à déposer les couches métalliques par électrolyse sur les surfaces (5, 6) métallisées, les réseaux pour des éléments à produire différemment étant branchés séparément dans le temps et des métaux différents étant ainsi déposés.

7. Procédé suivant la revendication 6, dans lequel on dépose par électrolyse des alliages de SnPb sur les surfaces (5, 6) métallisées du flan (1) multiple.

8. Procédé suivant la revendication 6 ou 7, dans lequel on dépose par électrolyse pour former des bossages (13) des couches en SnPb sur les surfaces (5) métallisées du flan (1) multiple qui sont prévues pour la réalisation d'un contact avec des bossages et on les porte ensuite à leur point de fusion.

9. Procédé suivant la revendication 8, dans lequel on agrandit, par dépôt d'une succession (23) de couches les surfaces (5) métallisées du flan multiple prévues pour la réalisation d'un contact de bossage (13) et données à l'avance par le diamètre des contacts (20) traversants, ménagés dans le flan (1) multiple et ensuite on dépose galvaniquement les couches de métal nécessaires à la formation de bossages et on les porte à leur point de fusion.

10. Procédé suivant la revendication 9, dans lequel on dépose par électrolyse ou sans mise en oeuvre de courant une succession de couches W-Ni-Au (23) par une technique de sérigraphie.
